Europäisches Patentamt

· European Patent Office

Office européen des brevets

(19)

(11) Veröffentlichungsnummer: **0 001 433**
**B1**

(12) **EUROPÄISCHE PATENTSCHRIFT**

(45) Veröffentlichungstag der Patentschrift:
**18.03.81**

(21) Anmeldenummer: **78101008.7**

(22) Anmeldetag: **27.09.78**

(51) Int. Cl.³: **H 01 L 29/747, H 01 L 29/06**

(54) Zweiweg-Halbleiterschalter (Triac).

(30) Priorität: **08.10.77 DE 2745361**

(43) Veröffentlichungstag der Anmeldung:
**18.04.79 Patentblatt 79/8**

(45) Bekanntmachung des Hinweises auf die Patenterteilung:
**18.03.81 Patentblatt 81/11**

(84) Benannte Vertragsstaaten:
**CH FR GB NL**

(56) Entgegenhaltungen:
**CH-A-574 168**
**DE-A-2 523 754**
**FR-A-1 513 238**

(73) Patentinhaber: **BROWN, BOVERI & CIE**
**Aktiengesellschaft Mannheim, Kallstadter Strasse 1,**
**D-6800 Mannheim Käfertal (DE)**

(72) Erfinder: **Gernoth, Hartwig, Biedensandstrasse 13,**
**D-6840 Lampertheim (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchgebühr entrichtet worden ist (Art. 99(1) Europäisches Patentübereinkommen).

BUNDESDRUCKEREI BERLIN

Zweiweg-Halbleiterschalter (Triac)

Die Erfindung bezieht sich auf einen Zweiweg-Halbleiterschalter (Triac) mit einer aus drei Zonen abwechselnd entgegengesetzten Leitungstyps bestehenden scheibenförmigen Ausgangsstruktur, mit in Teilbereichen derselben liegenden, an die beiden Hauptoberflächen der Halbleiterscheibe austretenden Emitter- und Anodenzonen und mit zwei in Teilbereichen der ersten Zone der Ausgangsstruktur liegenden, an die erste Hauptoberfläche austretenden Steuerzonen unterschiedlichen Leitungstyps, wobei die Emitter- und Anodenzonen sowie jeweils an die entsprechende Hauptoberfläche austretende Teile der ersten bzw. dritten Zone der Ausgangsstruktur von einer ersten bzw. zweiten Hauptelektrode und die Steuerzonen von einer Steuerelektrode kontaktiert sind. Der Triac findet Anwendung zum Schalten hoher Leistungen.

Ein derartiger Triac ist aus der DE-OS 23 51 783 bekannt. Er kann über eine einzige Steuerelektrode gezündet bzw. in beiden Hauptstromrichten durchgeschaltet werden. Mit anderen Worten: Der Triac kann in vier Betriebsweisen bzw. im Vier-Quadrantenbetrieb eingesetzt werden, wobei die erste Hauptelektrode negativ oder positiv gegenüber der zweiten Hauptelektrode und die Steuerelektrode jeweils bezüglich der ersten Hauptelektrode entweder positiv oder negativ sein kann.

Im bekannten Fall werden durch Vergrößerung der Eindringtiefen der Emitterzone unter der zweiten Hauptelektrode und/oder der zweiten Steuerzone unter der Steuerelektrode sowie durch eine größere Emitterkurzschlußdichte an der zweiten Hauptelektrode eine weitgehende Symmetrierung der für die genannten Betriebsweisen erforderlichen Steuerstromhöhen sowie eine Erniedrigung derselben erreicht. Das Ergebnis genügt dabei bis zu Spannungen von 600 V den schaltungstechnischen Anforderungen. Bei höheren Spannungen, z. B. bei 1200 V, sind jedoch bereits kleine Abweichungen von der Zündsymmetrie nachteilig. Wegen der verschiedenen Steuerelektrodenarten (Normalgate und remote gate) ist eine leichte Unsymmetrie trotz symmetrisch aufgebauter Triac-Strukturen stets vorhanden.

Es ist bereits vorgeschlagen worden, diese Unsymmetrie durch über laterale Änderungen hinausgehende Strukturveränderungen positiv zu beeinflussen (deutsche Patentanmeldung P 26 36 234.5). Im bekannten Fall sind zwei mit äußeren Anschlüssen versehene Steuerelektroden vorgesehen. Die beiden Thyristoren, der Normal-Thyristor und der Invers-Thyristor, dieses Systems sind voneinander durch eine Ausnehmung in einer Hauptoberfläche entkoppelt. Dabei wird das Zündverhalten des ansonsten erst bei höheren Steuerströmen bzw. später durchschaltenden Invers-Thyristors und das des Normal-Thyristors aneinander angenähert, so daß bei Phasenanschnittsteuerung störende Rückwirkungen, z. B. in Niederspannungsverteilernetzen, vermieden sind.

Der Erfindung liegt, ausgehend vom Triac der eingangs beschriebenen Gattung mit einer einzigen Steuerelektrode, die Aufgabe zugrunde, eine Verbesserung der Zündsymmetrie auch für hohe Spannungen zu erreichen.

Die Lösung dieser Aufgabe besteht darin, daß die unter der ersten Hauptelektrode liegende erste Zone eine größere Dicke und höhere Querleitfähigkeit besitzt als der mindestens unterhalb der Steuerelektrode liegende Teilbereich der unter der zweiten Hauptelektrode liegenden dritten Zone.

Damit wird ähnlich wie im bekannten Fall durch die vergrößerten Eindringtiefen der Emitterzonen unter der zweiten Hauptelektrode, das Schaltverhalten für die Ansteuerung über die jeweilige Steuerzone bzw. auch für beide Hauptstromrichtungen gleich.

Es genügt für diesen Zweck auch, daß die dritte Zone nur in einem Teilbereich unterhalb der Steuerelektrode eine kleinere Dicke und geringe Querleitfähigkeit als die erste Zone besitzt. Dies entspricht etwa der Vergrößerung der Eindringtiefe der zweiten Steuerzone unterhalb der Steuerelektrode im bekannten Fall.

Die Erfindung wird nachfolgend anhand des in der Zeichnung dargestellten Ausführungsbeispiels näher erläutert. Es zeigt

Fig. 1 ein schematisches Schnittbild des Zweiweg-Halbleiterschalters und

Fig. 2 bis 4 schematisch das Herstellungsverfahren für den Zweiweg-Halbleiterschalter.

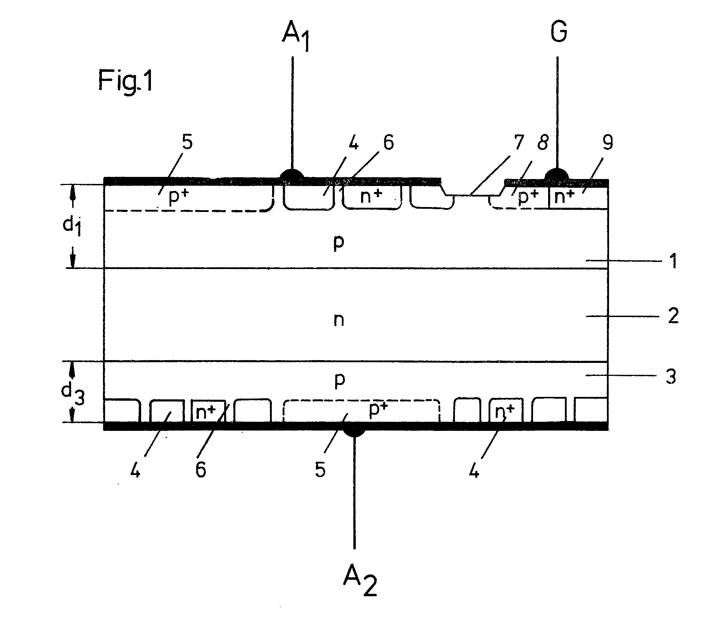

Das Schnittbild nach Fig. 1 zeigt den Zonenaufbau nur schematisch, weil einmal ein Schnitt durch den Halbleiterkörper nicht alle Zonen erfaßt und zum anderen die für die Erfindung wesentlichen Merkmale aus der schematischen Darstellung besser zu entnehmen sind. Der grundsätzliche Aufbau und die Wirkungsweise eines Triacs sind z. B. in der DE-OS 14 89 894 (vergleiche auch Proceedings of the IEEE, April 1965, Seiten 355 bis 369) erläutert.

Die Ausgangsstruktur des Triac besteht aus drei Zonen 1, 2 und 3 abwechselnd entgegengesetzten Leitungstyps. In der ersten Zone 1 und in der dritten Zone 3 befinden sich jeweils die Emitter- bzw. Anodenrandzonen 4 bzw. 5. Sie sind jeweils $n^+$- bzw. $p^+$-dotiert. Durch die Emitterzonen 4 treten, Nebenschlüsse an den Hauptelektroden A 1 bzw. A 2 bildend, jeweils Teile 6 der ersten Zone 1 bzw. der dritten Zone 3 an die erste bzw. zweite Hauptoberfläche. Eine Steuerelektrode G ist durch eine Rille (Gate-Graben) 7 von den von der ersten Hauptelektrode A 1 kontaktierten Zonen 4, 5 bzw. Teilen 6 getrennt. Unter der Steuerelektrode G liegen eine erste Steuerzone 8, d. h. ein hochdotierter Bereich ($p^+$) der ersten Zone 1, und eine zweite Steuerzone 9 des Leitungstyps $n^+$. Die Dicke $d_1$

der ersten Zone 1 ist größer als die Dicke $d_3$ der dritten Zone 3.

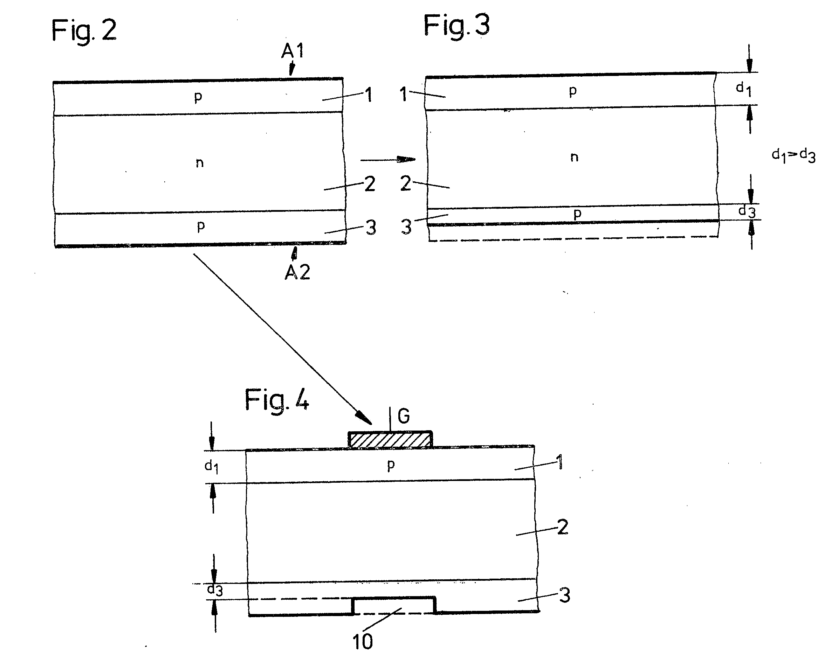

Anhand der Fig. 2 bis 4 wird nachfolgend die Herstellung des erfindungsgemäßen Triacs erläutert.

Ausgegangen wird von einer symmetrischen pnp-Ausgangsstruktur, wie sie nach einer p-Diffusion in n-Silizium vorliegt. Diese Diffusion kann eine Bor-, Gallium- oder Aluminium-Diffusion sein oder eine Kombination dieser drei Möglichkeiten. Die Dicke der ersten Zone 1 ist also zunächst gleich der Dicke der dritten Zone. Zur Erzeugung des unsymmetrischen Systems wird die p-leitende dritte Zone 3 auf der Seite der späteren Anodenfläche A 2 abgetragen. Die Abtragsrate ist dabei so zu bemessen, daß die gewünschte Zündsymmetrie erreicht wird. Diese hängt ab von der Art des Dotierungsprofils in der dritten Zone 3. Das Abtragen kann nach den an sich bekannten Verfahren erfolgen, z. B. Abläppen oder Abätzen. Zum Beispiel können zum Abätzen von Silizium Kombinationen aus Salpetersäure und Flußsäure dienen, weiterhin auch Ätzalkalien, oder Lösungen aus Silbernitrat, destilliertem Wasser, Salpetersäure und Fluorwasserstoffsäure und anderen.

Es genügt auch, die Abtragung auf einen Teilbereich 10 unterhalb der Steuerelektrode zu begrenzen (Fig. 4). Mit der Tiefe der Abläppung bzw. Abätzung (lokal wie global) kann die Größe der Querleitfähigkeit der dritten Zone 3 bzw. des über dem Teilbereich 10 liegenden Teiles derselben eingestellt werden.

Nach dem Abtragen und dem Entfernen von Säureresten erfolgt die normale Weiterverarbeitung zum fertigen Triac-Chip.

Der Abtragungsprozeß stellt herstellungstechnisch gesehen einen Vorteil gegenüber der Einstellung unterschiedlicher Diffusionstiefen im bekannten Fall (DE-OS 23 51 783) dar. Jedoch kann in weiterer Ausgestaltung der Erfindung die vorbeschriebene Abtragung auch mit der bekannten Einstellung unterschiedlicher Eindringtiefen kombiniert werden.

**Patentansprüche**

1. Zweiweg-Halbleiterschalter (Triac) mit einer aus drei Zonen abwechselnd entgegengesetzten Leitungstyps bestehenden scheibenförmigen Ausgangsstruktur, mit in Teilbereichen derselben liegenden, an die beiden Hauptoberflächen der Halbleiterscheibe austretenden Emitter- und Anodenzonen und mit zwei in Teilbereichen der ersten Zone der Ausgangsstruktur liegenden, an die erste Hauptoberfläche austretenden Steuerzonen unterschiedlichen Leitungstyps, wobei die Emitter- und Anodenzonen sowie jeweils an die entsprechende Hauptoberfläche austretende Teile der ersten bzw. dritten Zone der Ausgangsstruktur von einer ersten bzw. zweiten Hauptelektrode und die Steuerzonen von einer Steuerelektrode kontaktiert sind, dadurch gekennzeichnet, daß die unter der ersten Hauptelektrode (A 1) liegende erste Zone (1) eine größere Dicke ($d_1$) und höhere Querleitfähigkeit besitzt als der mindestens unterhalb der Steuerelektrode (G) liegende Teilbereich (10) der unter der zweiten Hauptelektrode (A2) liegenden dritten Zone (3) ($d_3$).

2. Zweiweg-Halbleiterschalter nach Anspruch 1, dadurch gekennzeichnet, daß die dritte Zone (3) nur in dem Teilbereich (10) unterhalb der Steuerelektrode (G) eine kleinere Dicke ($d_3$) und geringere Querleitfähigkeit als die erste Zone (1) besitzt.

**Claims**

1. A bidirectional semiconductor switch (triac) comprising a plate-shaped starting structure consisting of three zones of alternately opposite conductivity type, emitter and anode zones which are disposed in partial areas of the said starting structure and which open on to the two main surfaces of the semiconductor plate, and two control zones of opposite conductivity type to one another which are disposed in partial areas of the first zone of the starting structure and which open on to the first main surface, wherein the emitter and anode zones and parts of the first and third zone respectively of the starting structure which open on to the corresponding main surface in each case are contacted by a first and second main electrode respectively and the control zones are contacted by a control electrode, characterized in that the first zone (1) disposed beneath the first main electrode (A 1) has a greater thickness ($d_1$) and higher transverse conductivity than at least that part (10) of the area of the third zone (3) disposed beneath the second main electrode (A 2) which is disposed in line with the control electrode (G) ($d_3$).

2. A bidirectional semiconductor switch according to Claim 1, characterized in that the third zone (3) has a smaller thickness ($d_3$) and lower transverse conductivity than the first zone (1) only in the partial area (10) beneath the control electrode (G).

**Revendications**

1. Commutateur bidirectionnel commandé à semiconducteur (triac) à structure initiale discoïde formée de trois zones de types de conduction opposés en alternance, comprenant des zones d'émetteur et d'anode situées dans des régions de cette structure et émergeant des deux surfaces principales du disque semiconducteur ainsi que deux zones de commande de types différents de conduction qui émergent de la première surface principale dans des régions de la première zone de la structure initiale, les zones d'émetteur et d'anode ainsi que les régions des première et troisième zones de la structure initiale qui émergent de la surface principale correspondante étant en contact avec des première et seconde électrodes principales et les zones de commande étant en contact avec une électrode de commande, commutateur caractérisé en ce que la première zone (1) située sous la première électrode principale ($A_1$) a une épaisseur plus grande ($d_1$) et une conductivité transversale plus élevée que la région (10) qui se trouve au moins sous l'électrode de commande (G) et qui fait partie de la troisième zone (3) ($d_3$) qui est située sous la seconde électrode principale ($A_2$).

2. Cummutateur bidirectionnel commandé à semi-conducteur selon la revendication 1, caractérisé en ce que la troisième zone (3) n'a une épaisseur plus faible ($d_3$) et une conductivité transversale plus faible que celles de la première zone (1) que dans la région (10) située sous l'électrode de commande (G).

Fig.1

$A_1$

G

$A_2$

## Fig. 2

A1

| | |
|---|---|
| p | 1 |
| n | 2 |
| p | 3 |

A2

## Fig. 3

| | | |
|---|---|---|
| 1 | p | $d_1$ |
| 2 | n | |
| 3 | p | $d_3$ |

$d_1 > d_3$

## Fig. 4

G

| | |
|---|---|
| $d_1$ | p | 1 |
| | | 2 |
| $d_3$ | | 3 |

10

0 001 433